# EUROPEAN PATENT APPLICATION

(11) **EP 2 400 824 A1**
(43) Date of publication of application: **28.12.2011**
(21) Application number: 11157958.7
(22) Date of filing: 11.03.2011
(51) Int. Cl.: H05K 3/34, H05K 1/18

(54) **Packaging structure, printed circuit board assembly and fixing method**

(30) Priority: 14.06.2010 JP 2010135115
(71) Applicant: FUJITSU LIMITED, Kawasaki-shi, Kanagawa 211-8588 (JP)
(72) Inventor: Kobayashi, Hiroshi, Kawasaki-shi Kanagawa 211-8588 (JP); Okada, Toru, Kawasaki-shi Kanagawa 211-8588 (JP); Emoto, Satoshi, Kawasaki-shi Kanagawa 211-8588 (JP); Kitajima, Masayuki, Kawasaki-shi Kanagawa 211-8588 (JP)
(74) Representative: Stebbing, Timothy Charles

(57) **Abstract**

A packaging structure for mounting an electronic component on a printed circuit board is provided, which includes an external connecting terminal of the electronic component connected to an electrode pad of the printed circuit board; a through-hole penetrating through the printed circuit board, the through-hole formed in a periphery of an electronic component mounting area; and a clamping member including a middle portion extending through the through-hole, and a first end portion and a second end portion extending from the middle portion. The first end portion and the second end portion are bent such that the electronic component and the printed circuit board are sandwiched and clamped by the first end portion and the second end portion.

## Description

### FIELD

A certain aspect of the embodiments discussed herein is related to an electronic component packaging structure, a printed circuit board assembly and a fixing method.

### BACKGROUND

Electronic apparatuses typically include a printed circuit board on which electronic components such as semiconductor devices are mounted. Since the printed circuit boards on which the electronic components such as semiconductor devices are densely mounted have been reduced in size, electronic apparatuses including such printed circuit boards are increasingly becoming compact. With the reduction in size of the printed circuit board, a packaging structure of the electronic components mounted on the printed circuit board is also becoming compact.

As a bonding material for bonding the semiconductor device mounted on the printed circuit board, a solder bump may be frequently utilized. The semiconductor device is electrically connected to the printed circuit board by solder bonding the semiconductor device to the printed circuit board with the solder bump while the semiconductor device is mechanically fixed to the printed circuit board. As descried above, the packaging structure of the electronic components mounted on the printed circuit board is becoming compact, and hence the solder bump and the solder bonding portion are becoming small. With such a packaging structure, the solder bump bonding portion may be easily deformed by thermal stress or external pressure, thereby causing poor electric connection.

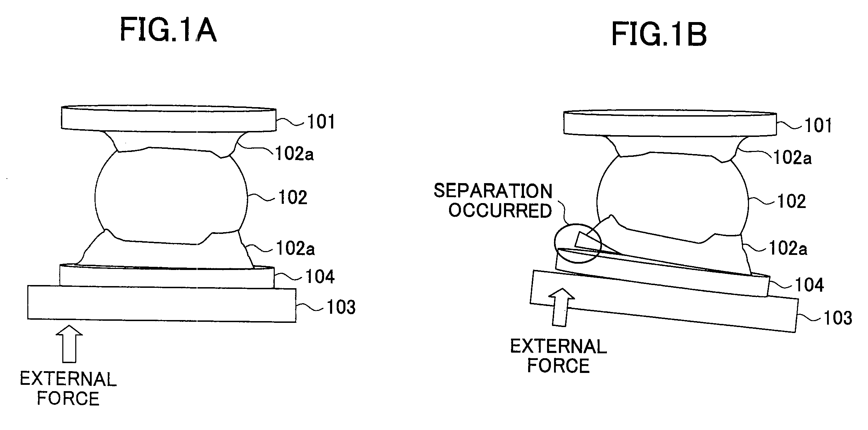

FIGS. 1A and 1B illustrate an example of the packaging structure in which the solder bump is deformed when external force is applied to the solder bump bonding portion. FIG. 1A illustrates a packaging structure where an electrode pad 101 of a semiconductor device is bonded to a connecting pad 104 of a printed circuit board 103. The solder bump 102 is initially melted and then solidified to reflow solder the semiconductor device, thereby forming respective solder bonding portions 102a that are tightly attached to the electrode pad 101 and the connecting pad 104. FIG. 1A illustrates the packaging structure where external force is yet to be applied to the solder bump 102, and hence the solder bump 102 is not deformed.

When external force is applied to the printed circuit board 103 at a position indicated by a thick upward arrow illustrated in FIG. 1A, a portion of the printed circuit board 103 to which the external force is applied is upwardly deformed, and the solder bump 102 is also deformed as illustrated in FIG. 1B. Since the position to which the external force is applied is located off a center of the solder bump 102, stress is applied to one end of the solder bonding portion 102a near the position where the external force is applied. When no more external force is applied to that position, the stress is not applied to the position. As a result, a shape of the solder bump 102 returns to the shape of the solder bump 102 illustrated in FIG. 1A.

If such external force is repeatedly applied to the printed circuit board 103, stress is repeatedly applied to a portion between the solder bonding portion 102a and the connecting pad 104, which may separate the end of the solder bonding portion 102a from the connecting pad 104. If the separated portion between the end of the solder bonding portion 102a and the connecting pad 104 is becoming large, electric connection between the solder bonding portion 102a and the connecting pad 104 may be interfered with, thereby causing poor electric connection.

Accordingly, an underfill material is supplied between the mounted semiconductor device and the printed circuit board in order to reinforce the solder bonding portion. That is, a periphery of the solder bonding portion is reinforced by supplying the underfill material composed of epoxy resin or the like in the periphery of the solder bonding portion, and in addition, a bottom face of the semiconductor device and a surface of the printed circuit board are mechanically fixed by adhering them with the underfill material. Thus, pressure resistance and long-term reliability of the solder bonding portion may be improved.

Specifically, since recent electronic apparatuses such as note-type mobile computers or mobile phones have increasingly becoming compact with high functionality, pressure applied to a case of the electronic apparatus may be easily transmitted to the internal printed circuit board or a packaging structure portion on the printed circuit board. Thus, it is preferable that an underfill material including higher adhesive strength and higher Young's modulus be utilized for improving the pressure resistance and long-term reliability of the solder bonding portion. However, if the adhesive strength of the underfill material is too high, it may be difficult to detach or dismount the semiconductor device once fixed to the printed circuit board with the underfill material from the printed circuit board.

For example, if the semiconductor device having been already mounted on the printed circuit board exhibits malfunction, it may be difficult to solely dismount the semiconductor device that exhibits the malfunction from the printed circuit board to replace it with a new one. In this case, the expensive whole printed circuit board including various electronic components including the semiconductor device that exhibits the malfunction may be replaced with a new printed circuit board, which may result in high defective work cost of the printed circuit board. Further, since it is difficult to solely examine the semiconductor device that appears to exhibit the malfunction, the cause of the malfunctioning may not be analyzed or clarified, which may result in an increase in a fractional defective level.

Japanese Laid-Open Patent Application No. 2003-347486 (hereinafter referred to as "JP-A-2003-347486"), for example, discloses a packaging structure in which a radiator plate formed as a large clip is utilized for sandwiching a printed circuit board and a semiconductor component to fix the semiconductor component to the printed circuit board. With this configuration, since a sandwiching force is constantly applied from the clip to the semiconductor component, external connecting terminals of the semiconductor component are constantly pressed by the electrode pad. Accordingly, poor electric connection may not result. Further, with this configuration, the semiconductor component may not necessarily be fixed to the printed circuit board with an adhesive material such as the underfill material to exert connecting reliability, and the semiconductor component mounted on the printed circuit board may easily be detached or dismounted from the printed circuit board by simply removing the clip.

In the packaging structure disclosed in
JP-A-2003-347486, a large sized U-shaped clip including an opening at one side sandwiches the semiconductor component stacked on the printed circuit board. If the semiconductor component is mounted near an edge of the printed circuit board, the above clip is utilized for sandwiching the semiconductor component stacked on the printed circuit board. However, if the semiconductor component is mounted at a center of the printed circuit board, a long clip to reach the semiconductor component may be required, and hence it may not be practical to utilize such a clip.

### SUMMARY

Accordingly, it is an object in one aspect of the invention to provide a packaging structure capable of easily detaching the mounted semiconductor device from the printed circuit board without utilizing the underfill material while improving pressure resistance and long-term reliability of the solder bonding portion of the semiconductor device.

According to an aspect of an embodiment, a packaging structure for mounting an electronic component on a printed circuit board includes an external connecting terminal of the electronic component connected to an electrode pad of the printed circuit board, a through-hole penetrating through the printed circuit board, the through-hole formed in a periphery of an electronic component mounting area, and a clamping member including a middle portion extending through the through-hole, and a first end portion and a second end portion extending from the middle portion. In the packaging structure, the first end portion and the second end portion are bent such that the electronic component and the printed circuit board are sandwiched and clamped by the first end portion and the second end portion.

### BRIEF DESCRIPTION OF THE DRAWINGS

FIGS. 1A and 1B are diagrams illustrating an example of a packaging structure in which a solder bump is deformed when external force is applied to the solder bump bonding portion;
FIG. 2 is a plan diagram illustrating an example of a printed circuit board assembly including a packaging structure according to an embodiment;
FIG. 3 is a cross-sectional diagram taken along a III-III broken line of FIG. 2;
FIG. 4 is a perspective diagram illustrating an example of a semiconductor device fixed with clamping members to the printed circuit board;
FIGS. 5A through 5E are diagrams illustrating exemplary steps in which the printed circuit board and the semiconductor device are sandwiched by a clamping member;
FIGS. 6A through 6C are diagrams illustrating exemplary steps in which the printed circuit board and the semiconductor device are sandwiched by a clamping member;
FIG. 7 is a plan diagram illustrating an example of a printed circuit board assembly formed by mounting a semiconductor device including a non-resin-sealed semiconductor chip on the printed circuit board;
FIG. 8 is a plan diagram illustrating an example of a printed circuit board assembly formed by mounting a semiconductor device including a packaging substrate an entire surface of which is covered with a resin-sealed portion on the printed circuit board;
FIG. 9 is a cross-sectional diagram taken along a IX-IX broken line of FIG. 8;
FIG. 10 is a perspective diagram illustrating an example of a printed circuit board assembly in which four corners of a semiconductor device are fixed to the printed circuit board with small sized clamping members;
FIG. 11 is a perspective diagram illustrating an example of a printed circuit board assembly in which sides of a semiconductor device are fixed to the printed circuit board with a frame shaped clamping member;
FIG. 12 is a perspective diagram illustrating an example of a printed circuit board assembly viewed from a rear side thereof in which four corners of a semiconductor device are fixed with a frame shaped clamping member;
FIG. 13 is a table illustrating results of stress applied to a solder bump obtained by simulations where the semiconductor device is fixed with different types of the clamping member;
FIG. 14 is a diagram illustrating a first modification of the clamping member;
FIG. 15 is a diagram illustrating a second modification of the clamping member; and
FIG. 16 is a diagram illustrating an example of the clamping member including an engaging portion and a fixing portion when the engaging portion is separated from the fixing portion.

### DESCRIPTION OF EMBODIMENTS

A description is given, with reference to the accompanying drawings, of embodiments of the present invention.

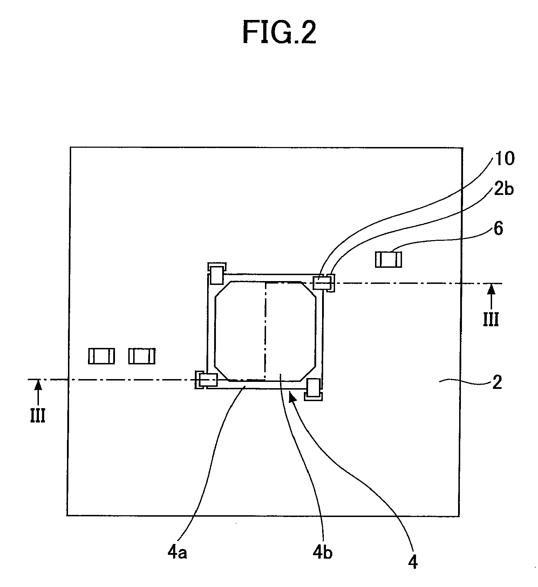

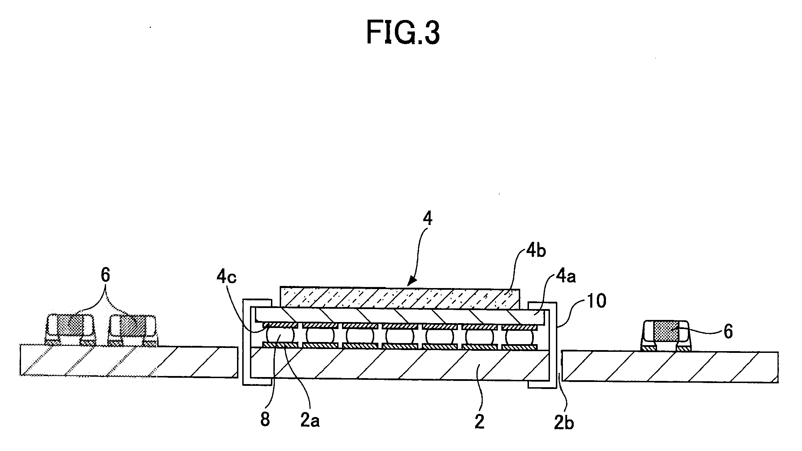

FIG. 2 is a plan diagram illustrating an example of a printed circuit board assembly including a packaging structure according to an embodiment. FIG. 3 is a cross-sectional diagram taken along a III-III broken line of FIG. 2. The printed circuit board assembly illustrated in FIGS. 2 and 3 is formed by mounting a semiconductor device 4 illustrated as an example of the electronic component and passive elements 6 such as a resistor and a capacitor on a printed circuit board 2 including printed wiring. The printed circuit board 2 includes the printed wiring on its surface and/or inside of it. As illustrated in FIG. 3, an electrode 4c of the semiconductor device 4 is bonded to an electrode pad 2a of the printed circuit board 2 with a solder bump 8 provided as a bonding material.

The printed circuit board 2 may be an organic circuit board formed of an organic board material such as a glass epoxy board. The electrode pads 2a to which the respective electrodes 4c of the semiconductor device 4 are bonded via the solder bumps 8 are arranged on a surface of the printed circuit board 2.

As illustrated in the examples of FIGS. 2 and 3, the semiconductor device 4 is formed by mounting a semiconductor chip on a packaging substrate 4a (hereinafter also called a "substrate") and resin-sealing the semiconductor chip mounted on the packaging substrate 4a. The electrodes 4c are formed on a rear surface of the packaging substrate 4a (not illustrated) and the solder bumps 8 are bonded to the electrodes 4c as the external connecting terminals. A peripheral portion of the packaging substrate 4a is externally extended or projected from a resin-sealed portion 4b.

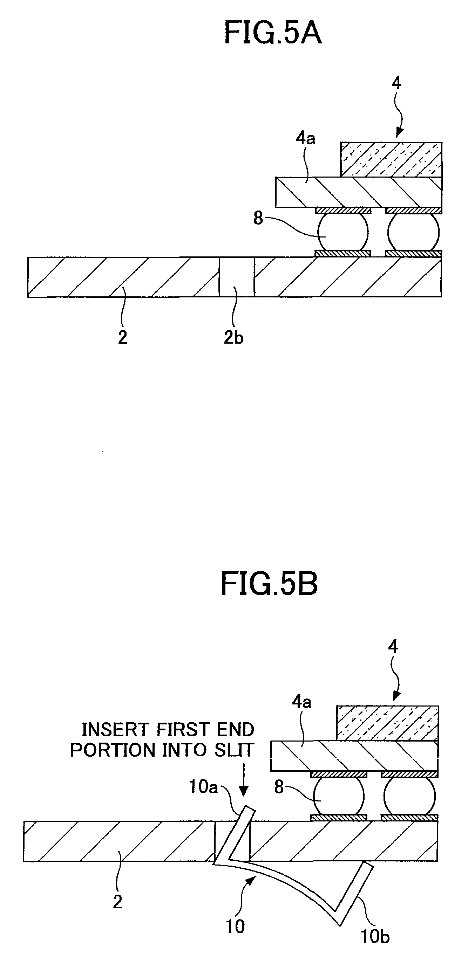

In this embodiment, the semiconductor device 4 is fixed to the printed circuit board 2 by allowing a clamping member 10 to extend through the printed circuit board 2 such that the printed circuit board 2 and the semiconductor device 4 are sandwiched by portions of the clamping member 10 while the semiconductor device 4 is pressed on the printed circuit board 2 with the sandwiching force applied by the clamping member 10. The clamping member 10 may be formed of a U-shaped metallic plate (e.g., SUS 304CSP) including a spring property, and the printed circuit board 2 and the semiconductor device 4 are sandwiched between two parallel end portions 10a and 10b (see FIG. 5B) of the U-shaped metallic plate. With this configuration, the semiconductor device 4 is constantly pressed by the printed circuit board 2 with clamping force of the clamping member 10.

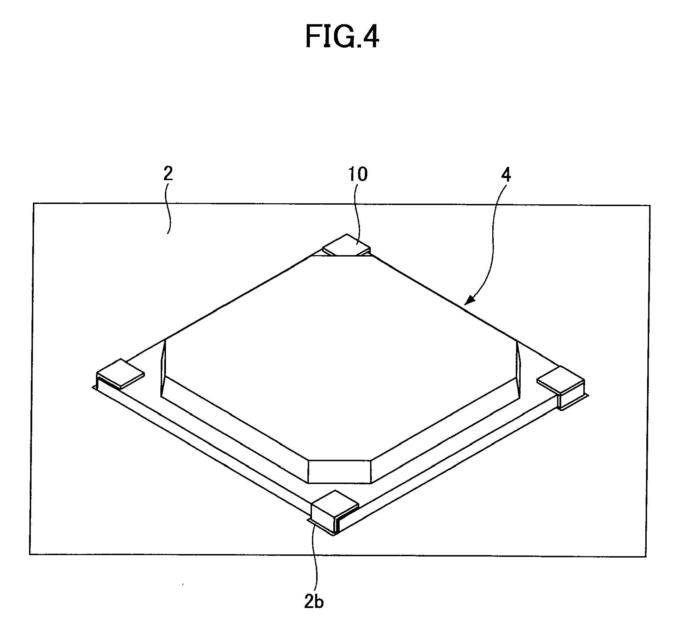

FIG. 4 is a perspective diagram illustrating an example of the semiconductor device 4 fixed with clamping members 10 to the printed circuit board 2. As illustrated in FIGS. 2 and 4, the four clamping members 10 are provided such that respective four corners of the semiconductor device 4 are sandwiched by the clamping members 10. Respective slits 2b are formed as through-holes in areas of the printed circuit board 2 such that the clamping members 10 extend through the slits 2b from a surface side to extend a rear surface side of the printed circuit board 2.

Below, a fixing method for fixing the semiconductor device 4 to the printed circuit board 2 by attaching the clamping members 10 to sandwich the printed circuit board 2 and the semiconductor device 4 is described. FIGS. 5A through 5E are diagrams illustrating exemplary steps in which the printed circuit board 2 and the semiconductor device 4 are sandwiched by the clamping member 10.

As illustrated in FIG. 5A, the slits 2b are formed in areas of the printed circuit board 2 corresponding to the four corners of the semiconductor device 4 (also see FIG. 4), where the clamping members 10 are allowed to extend through the slits 2b to simultaneously sandwich or clamp the printed circuit board 2 and the semiconductor device 4.

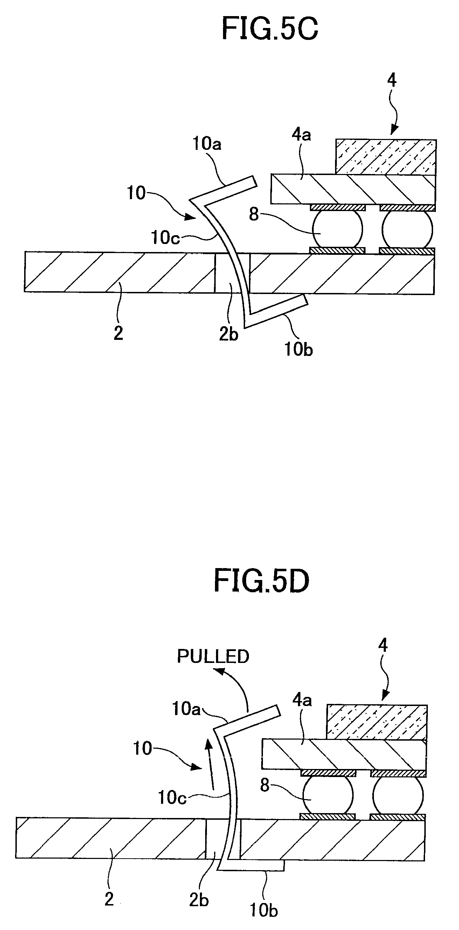

Initially, a first end portion 10a of the clamping member 10 is inserted into the slit 2b in a diagonal direction as illustrated in FIG. 5B. Subsequently, the clamping member 10 is further inserted into the slit 2b such that the first end portion 10a of the clamping member 10 is projected from a surface of the printed circuit board 2 and a second end portion 10b of the clamping member 10 is brought into contact with a rear surface of the printed circuit board 2, as illustrated in FIG. 5C. In this configuration, a middle portion 10c of the clamping member 10 extends through the slit 2b in the printed circuit board 2.

Subsequently, the first end portion 10a of the clamping member 10 is pulled out of the slit 2b while the second end portion 10b of the clamping member 10 is adjusted to be engaged with the rear surface of the printed circuit board 2. Accordingly, a space between the first end portion 10a and the second end portion 10b of the clamping member 10 is increased, as illustrated in FIG. 5D. The clamping member 10 is moved within the slit 2b such that the first end portion 10a of the clamping member 10 comes directly above a corner of the packaging substrate 4a.

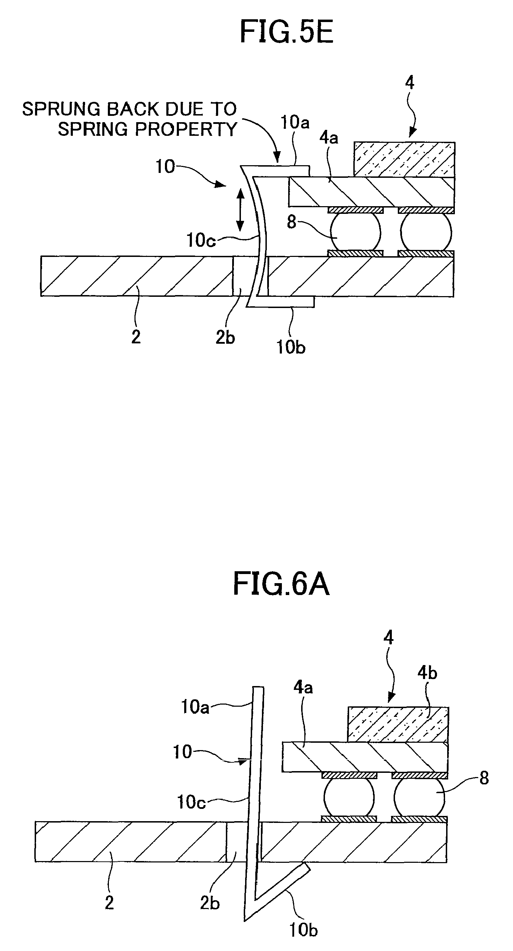

When the first end portion 10a is released, the clamping member 10 is sprung back to an original position due to a spring property so that the first end portion 10a of the clamping member 10 is engaged with the packaging substrate 4a, as illustrated in FIG. 5E. In this configuration, since the second end portion 10b is engaged with the rear surface of the printed circuit board 2, the packaging substrate 4a of the semiconductor device 4 and the printed circuit board 2 are sandwiched between the first end portion 10a and the second end portion 10b of the clamping member 10.

In the configuration where the clamping member 10 is attached to sandwich the printed circuit board and the semiconductor device 4, the semiconductor device 4 is pressed toward the printed circuit board 2 due to the spring property of the clamping member 10, and compressive force is constantly applied to the solder bump 8. Thus, tensile stress generated due to external force is not repeatedly applied to the bonding portion of the solder bump 8 so that breakage or separation of the bonding portion of the solder bump 8 may be suppressed, which may improve bonding reliability. Accordingly, the bonding reliability may be improved without utilizing the underfill material.

Further, with this configuration, the semiconductor device 4 is easily dismounted from the printed circuit board 2 by initially removing the clamping member 10 and then melting the solder bump 8. Alternatively, the solder bump 8 may be melted while the clamping member 10 remains attached to the packaging substrate 4a of the semiconductor device 4 and the printed circuit board 2 so as to allow the semiconductor device 4 to fall off. As a result, the clamping member 10 may be spontaneously detached from the semiconductor device 4.

Next, another fixing method for fixing the semiconductor device 4 to the printed circuit board 2 is described. FIGS. 6A through 6C are diagrams illustrating exemplary steps in which the printed circuit board 2 and the semiconductor device 4 are sandwiched by the clamping member 10.

As illustrated in the example of FIGS. 5A through 5E, the slits 2b are formed in areas of the printed circuit board 2 corresponding to the four corners of the semiconductor device 4 (also see FIG. 4), where the clamping members 10 are allowed to extend through the slits 2b to simultaneously sandwich or clamp the printed circuit board 2 and the semiconductor device 4. In the fixing method illustrated in FIGS. 6A through 6C, the clamping member 10 is bent in advance. As illustrated in FIG. 6A, the L-shaped clamping member 10 is inserted into the slit 2b of the printed circuit board 2. That is, compared to the example of FIGS. 5A through 5E, the second end portion 10b is bent and the first end portion 10a is linearly extended from the middle portion 10c in this example. Note that an initial bending angle of the second end portion 10b of the clamping member 10 is less than 90 degrees. The clamping member 10 is inserted into the slit 2b such that first end portion 10a extending from the middle portion 10c of the clamping member 10 is inserted into the slit 2b and continuously inserted into the slit 2b until the bent second end portion 10b is engaged with the rear surface of the printed circuit board 2.

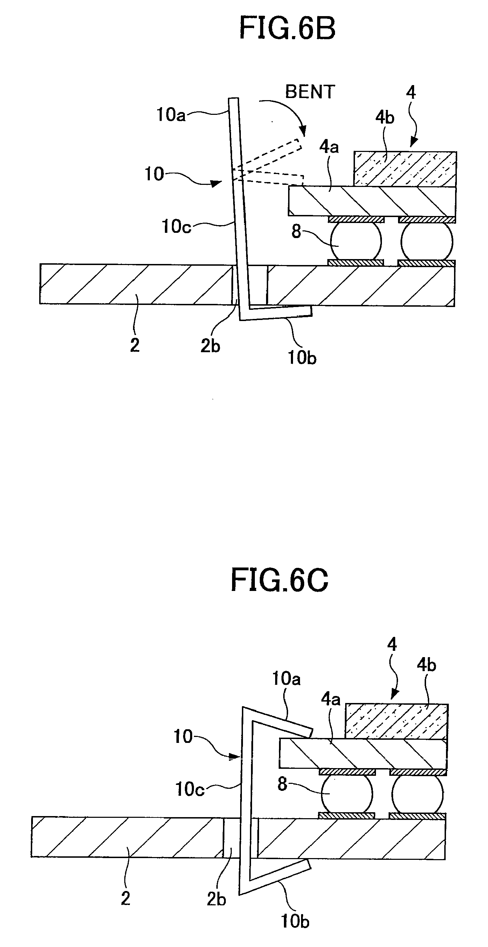

Subsequently, after the bent second end portion 10b of the clamping member 10 is brought into contact with the rear surface of the printed circuit board 2 such that the bending angle of the second end portion 10b becomes 90 degrees, the first end portion 10a of the clamping member 10 is bent such that the clamping member 10 is deformed to include a U-shaped configuration, as illustrated in FIG. 6B. When the first end portion 10a of the clamping member 10 is bent such that the first end portion 10a is brought into contact with or engaged with the packaging substrate 4a of the semiconductor device 4, the force applied to the first end portion 10a. of the clamping member 10 is released. Accordingly, since the bending angle of the second end portion 10b (of 90 degrees) returns to the initial bending angle of less than 90 degrees, the packaging substrate 4a of the semiconductor device 4 and the printed circuit board 2 are sandwiched between the first end portion 10a and the second end portion 10b of the clamping member 10, as illustrated in FIG. 6C. According to the fixing method illustrated in FIGS. 6A through 6C, the L-shaped clamping member 10 is inserted into the slit 2b of the printed circuit board 2 from the linear portion (i.e., first end portion 10a) of the L-shaped clamping member 10. Thus, the size of the slit 2b (i.e., opening) may be slightly greater than the cross-sectional shape of the clamping member 10.

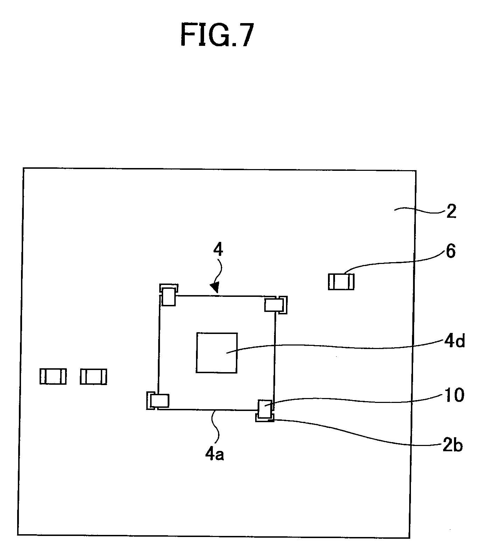

In the examples illustrated in FIGS. 2 through FIG. 6C, the periphery of the packaging substrate 4a of the semiconductor device 4 is extendedly projected from the resin-sealed portion 4b. However, a semiconductor chip 4d may not be resin-sealed in the semiconductor device 4 as illustrated in FIG. 7. FIG. 7 is a plan diagram illustrating an example of a printed circuit board assembly formed by mounting the semiconductor device 4 including the non-resin-sealed semiconductor chip 4d on the printed circuit board 2. In the example of FIG. 7, the clamping members 10 may be attached to the four corners of the packaging substrate 4a of the semiconductor device 4.

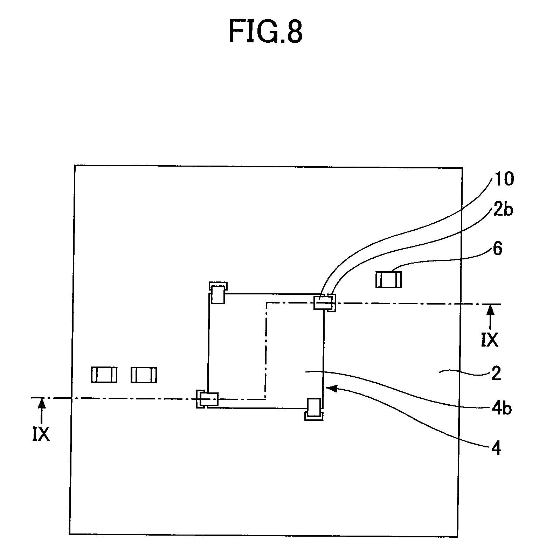

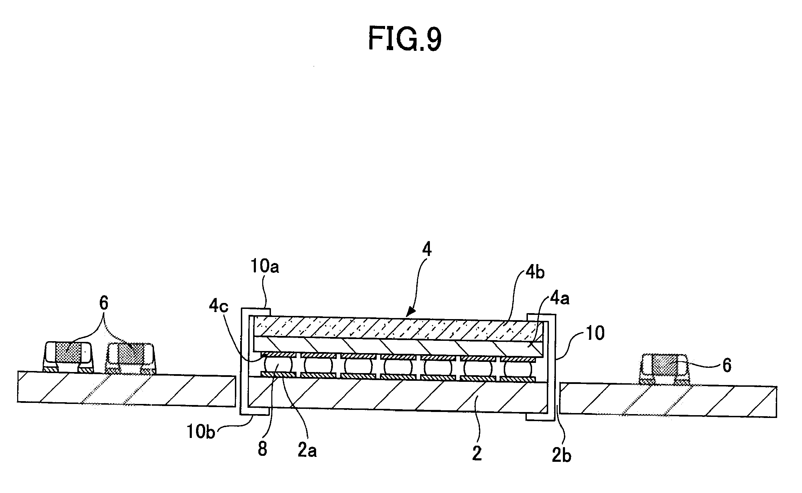

Further, if the entire surface of the packaging substrate 4a of the semiconductor device 4 is covered with the resin-sealed portion 4b, respective end portions of the clamping members 10 may be attached to four corners of the resin-sealed portion 4b of the semiconductor device 4. FIG. 8 is a plan diagram illustrating an example of a printed circuit board assembly formed by mounting the semiconductor device 4 including the packaging substrate 4a an entire surface of which is covered with a resin-sealed portion 4b on the printed circuit board. FIG. 9 is a cross-sectional diagram taken along a IX-IX broken line of FIG. 8. As illustrated in FIG. 9, the clamping members 10 are attached such that the first end portions 10a of the clamping members 10 are engaged with the four corners of the resin-sealed portion 4b of the semiconductor device 4, and the second end portions 10b of the clamping members 10 are engaged with the rear surface of the printed circuit board 2. With this configuration, the semiconductor device 4 and the.printed circuit board 2 are sandwiched between the first end portions 10a and the second end portions 10b of the clamping members 10.

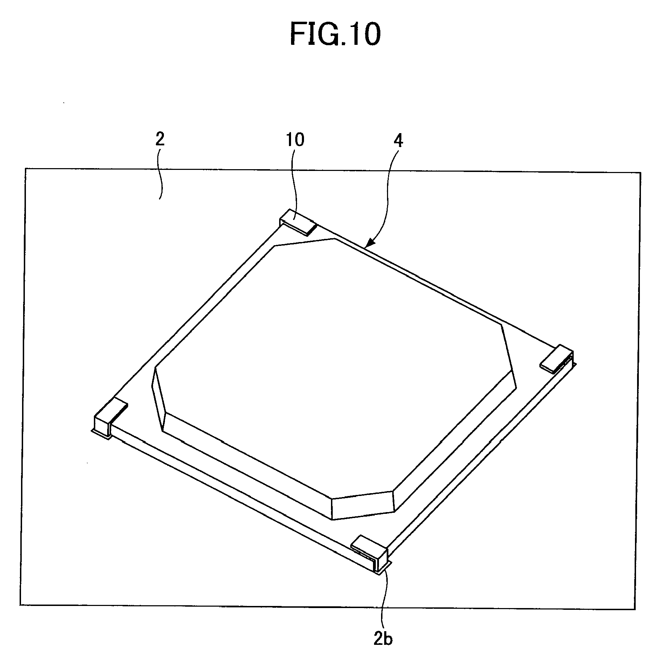

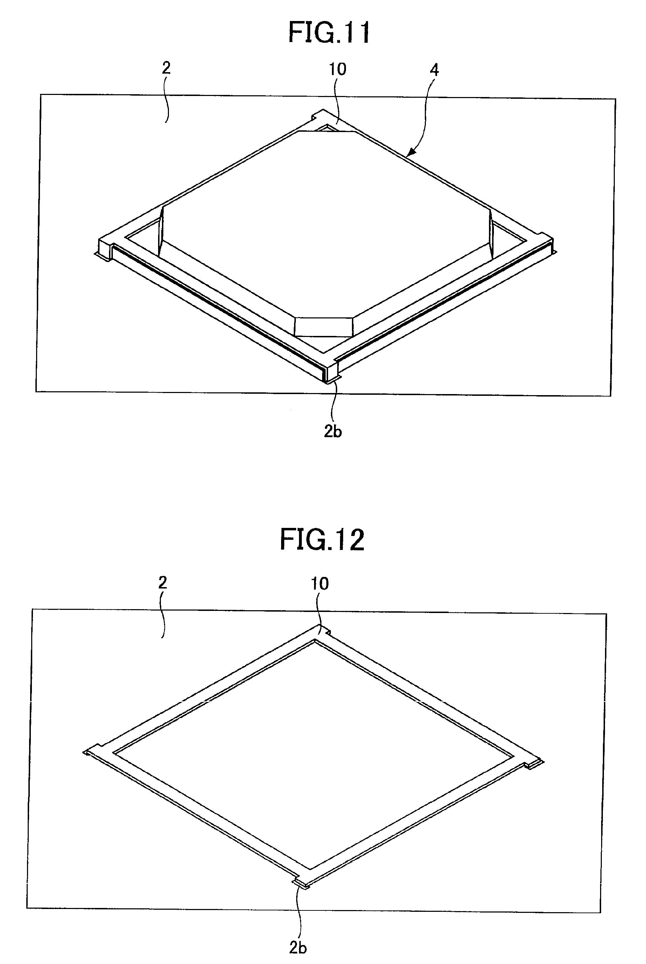

In the above-described examples, the four corners of the semiconductor device 4 are fixed to the printed circuit board 2 by the respective clamping members 10. However, sizes of the clamping members 10 may be made smaller as illustrated in FIG. 10. Alternatively, the clamping members 10 may be formed into a frame shaped clamping member 10 (i.e., one integrated clamping member) to fix four sides of the semiconductor device 4 to the printed circuit board 2, as illustrated in FIG. 11. In the frame shaped clamping member 10 illustrated in FIG. 11, portions (corresponding to first end portions) to be engaged with the four sides of the semiconductor device 4 form a frame, and thin middle portions correspondingly extending (projecting) from the portions engaged with the four sides of the clamping member 10 extend through the slits 2b of the printed circuit board 2 and further extend to the rear surface side of the printed circuit board 2. That is, a first frame portion (corresponding to first end portions) to be engaged with the four sides of the semiconductor device 4 correspond to the first end portions 10a, and not-illustrated second portions (corresponding to second end portions) extending from the middle portions to the rear surface (opposite) side of the printed circuit board correspond to the second end portions 10b. Accordingly, the semiconductor device 4 and the printed circuit board 2 are sandwiched between the first frame portion and the second portions of the frame shaped clamping member 10 with this configuration. In order to attach the frame shaped clamping member 10 to the semiconductor device 4 and the printed circuit board 2, while the second portions (corresponding to the second end portions 10b) and four middle portions (corresponding to the middle portions 10c) extending from the first frame portion (corresponding to the first end portions 10a) of the frame shaped clamping member 10 are inserted through the slits 2b from the surface side of the printed circuit board 2, the first frame portion is engaged with the four sides of the semiconductor device 4. Then, the second portions extending from the four middle portions are bent such that the first frame portion, the second portions and the middle portions of the clamping member 10 form a U-shape in a cross-section. Accordingly, the semiconductor device 4 and the printed circuit board 2 are sandwiched between the first frame portion and the second portions of the clamping member 10.

FIG. 12 is a perspective diagram illustrating an example of the printed circuit board 2 viewed from its rear surface side in a case where the frame shaped clamping member 10 is attached to the semiconductor device 4 and the printed circuit board 2 from the rear surface side of the printed circuit board 2. In this case, the first frame portion (corresponding to the first end portions 10a) of the frame shaped clamping member 10 is engaged with the rear surface of the printed circuit board 2, and the four middle portions (corresponding to the middle portions 10c) extending from the first frame portion extend through the slits 2b of the printed circuit board 2 and further extend to the surface side of the printed circuit board 2. Then, the second portions extending from the four middle portions are bent to be engaged with the four corners of the semiconductor device 4 such that the first frame portion, the second portions and the middle portions of the clamping member 10 form a U-shape in a cross-section. With this configuration, the semiconductor device 4 and the printed circuit board 2 are sandwiched between the first frame portion and the second portions of the clamping member 10 at the four corners of the semiconductor device 4.

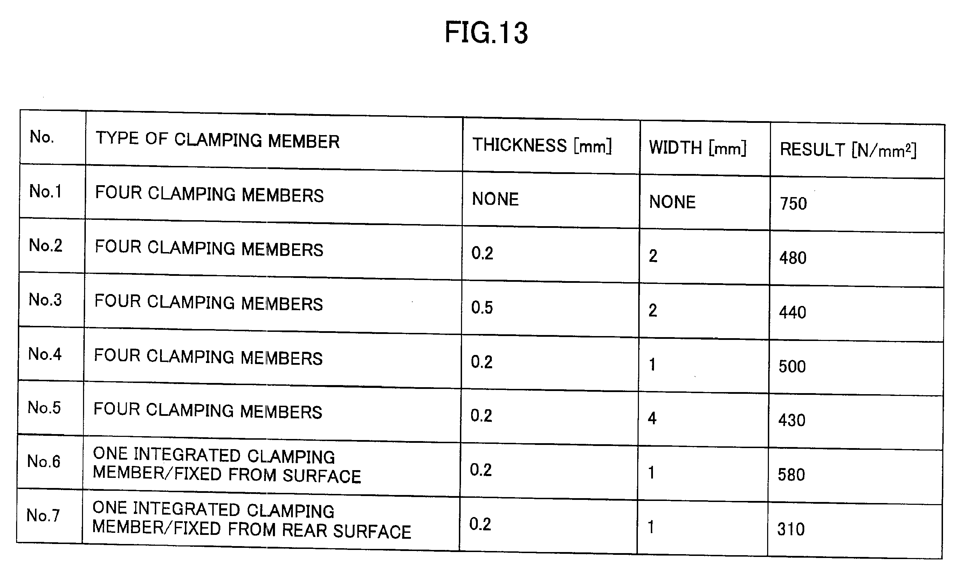

FIG. 13 is a table illustrating results of stress applied to a solder bump obtained by simulations where the semiconductor device is fixed with different types of the clamping member. The simulations are carried out to examine effects obtained by use of different types of the clamper for fixing the semiconductor device 4. The simulation conditions are as follows. A semiconductor device is a 27 mm square size semiconductor device, a printed circuit board is made of epoxy glass and includes a thickness of 1 mm, a solder bump includes a diameter of 0.6 mm, and an interval (distance) between the solder bumps is 1 mm. The semiconductor device is mounted on the printed circuit board based on the above conditions, and stress applied to the solder bumps when external force of 4 kg is applied to the printed circuit board is measured. In general, greatest stress is applied to the solder bumps that reside in the four corners of the semiconductor device, and thus, stress applied to the solder bump residing in the four corners of the semiconductor device is individually measured in the above model. Note that sufficient connecting reliability may be obtained if the stress applied to the solder bump is 500 N/mm² or less in this model.

In the table of FIG. 13, No. 1 indicates a simulation result obtained in a packaging structure where the semiconductor device is not fixed with a clamping member (i.e., a related art packaging structure). As may be seen from the simulation result of No. 1, the stress applied to the solder bump is 750 N/mm². No. 2 indicates a simulation result obtained in a packaging structure where the semiconductor device is fixed with four clamping members, a thickness of the clamping member is 0.2 mm, and a width of the clamping member is 2 mm. As may be seen from the simulation result of No. 2, the stress applied to the solder bump is 480 N/mm², which is lower than 500 N/mm².

In FIG. 13, No. 3 indicates a simulation result obtained in a packaging structure where the semiconductor device is fixed with four clamping members, a thickness of the clamping member is 0.5 mm, and a width of the clamping member is 2 mm. As may be seen from the simulation result of No. 3, the stress applied to the solder bump is 440 N/mm². This result illustrates that the stress applied to the solder bump is not significantly decreased even if the thickness of the clamping member is greater than 0.2 mm.

In FIG. 13, No. 4 indicates a simulation result obtained in a packaging structure where the semiconductor device is fixed with four clamping members, a thickness of the clamping member is 0.2 mm, and a width of the clamping member is 1 mm. As may be seen from the simulation result of No. 4, the stress applied to the solder bump is 500 N/mm². This result illustrates that the stress applied to the solder bump is not significantly increased even if the width of the clamping member is decreased to 1 mm.

In FIG. 13, No. 5 indicates a simulation result obtained in a packaging structure where the semiconductor device is fixed with four clamping members, a thickness of the clamping member is 0.2 mm, and a width of the clamping member is 4 mm. As may be seen from the simulation result of No. 5, the stress applied to the solder bump is 430 N/mm². This result illustrates that the stress applied to the solder bump is not significantly decreased even if the width of the clamping member is increased to 4 mm.

In FIG. 13, No. 6 indicates a simulation result obtained in a packaging structure where four sides of the semiconductor device are fixed with a frame shaped clamping member (i.e., one integrated clamping member) from a surface side of the printed circuit board (i.e., a packaging structure of FIG. 11), a thickness of the clamping member is 0.2 mm, and a width of the clamping member is 1 mm. As may be seen from the simulation result of No. 6, the stress applied to the solder bump is 580 N/mm².

In FIG. 13, No. 7 indicates a simulation result obtained in a packaging structure where four sides of the semiconductor device are fixed with a frame shaped clamping member (i.e., one integrated clamping member) from a rear side of the printed circuit board (i.e., a packaging structure of FIG. 12), a thickness of the clamping member is 0.2 mm, and a width of the clamping member is 1 mm. As may be seen from the simulation result of No. 7, the stress applied to the solder bump is 310 N/mm². Thus, the most significant effect is obtained in the packaging structure of No. 7. This result may be obtained because the frame shaped clamping member is engaged with the printed circuit board to prevent the printed circuit board from deforming.

Next, examples of the clamping member according to modifications are described.

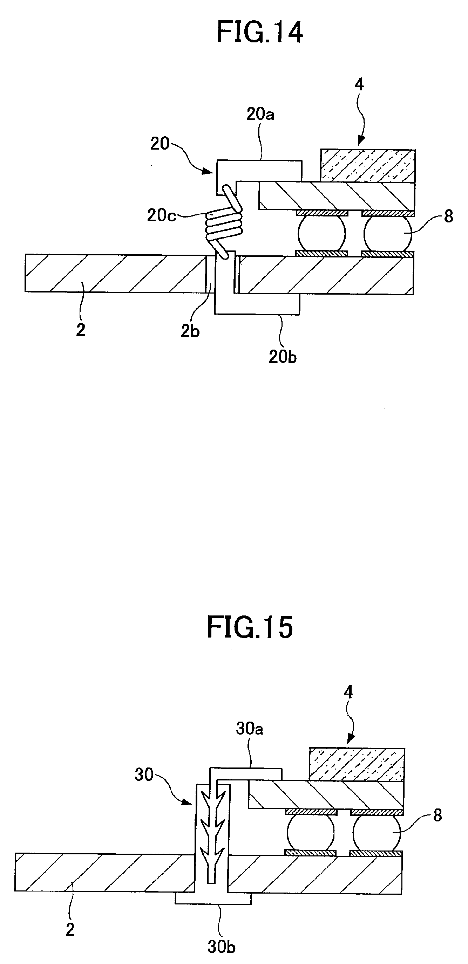

FIG. 14 is a diagram illustrating a first modification of the clamping member 10. A clamp member 20 according to the modification illustrated in FIG. 14 includes a spring 20c as the middle portion 10c of the clamping member 10 according to the embodiment. That is, a first end portion 20a and a second end portion 20c are connected via the spring 20c as illustrated in FIG. 14. The spring 20c is configured to apply pressure in directions so that a distance between the first end portion 20a and the second end portion 20b is narrowed.

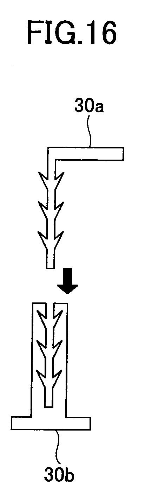

FIG. 15 is a diagram illustrating a second modification of the clamping member 10. A clamping member 30 according to the second modification illustrated in FIG. 15 includes an engaging portion 30a configured to be engaged with the semiconductor device 4 and a fixing portion 30b configured to be fixed to the printed circuit board 2. As illustrated in FIG. 16, a first end portion of the engaging portion 30a is inserted into a hole of the fixing portion 30b and to be engaged with an inner surface of the fixing portion 30b. The first end portion of the engaging portion 30a to be inserted into the hole of the fixing member 30 includes small projections and the inner surface of the fixing portion 30b includes small recesses.

When the engaging portion 30a is inserted into the hole of the fixing portion 30b, the small projections of the engaging portion 30a are engaged with the recesses of the inner surface of the fixing portion 30b. Thus, the engaging portion 30a is engaged with the fixing portion 30b. In this configuration, since a second end portion of the engaging portion 30a is engaged with the semiconductor device 4 while the first end portion of the engaging portion 30a is engaged with the inner surface of the fixing portion 30b, the semiconductor device 4 and the printed circuit board 30 are sandwiched between the second end portion of the engaging portion 30a and an end portion of the fixing portion 30b engaged with the rear surface of the printed circuit board 2.

As described above, the semiconductor device and the printed circuit board are fixed such that the semiconductor device and the printed circuit board are sandwiched by the clamping member that extends through the printed circuit board (via through-holes). Accordingly, the solder bump bonding portions are constantly compressed and bonding reliability may be improved. With this configuration, bonding reliability in bonding of the semiconductor device to the printed circuit board may be secured without use of the underfill material, and hence the semiconductor device may be easily removed from the printed circuit board.

All examples and conditional language recited herein are intended for pedagogical purposes to aid the reader in understanding the invention and the concepts contributed by the inventor to furthering the art, and are to be construed as being without limitation to such specifically recited examples and conditions, nor.does the organization of such examples in the specification relate to a showing of the superiority or inferiority of the invention. Although the embodiments of the present invention have been described in detail, it should be understood that the various changes, substitutions, and alterations could be made hereto without departing from the spirit and scope of the invention.

## Claims

1. A packaging structure for mounting an electronic component on a printed circuit board, comprising:
an external connecting terminal of the electronic component connected to an electrode pad of the printed circuit board;
a through-hole penetrating through the printed circuit board, the through-hole formed in a periphery of an electronic component mounting area; and
a clamping member including a middle portion extending through the through-hole, and a first end portion and a second end portion extending from the middle portion, wherein
the first end portion and the second end portion are bent such that the electronic component and the printed circuit board are sandwiched and clamped by the first end portion and the second end portion.

2. The packaging structure as claimed in claim **characterized in that**
the clamping member is formed of a metallic plate including a spring property.

3. The packaging structure as claimed in claim 1 or 2, **characterized in that**
the clamping member includes four clamping members that are separately provided such that the four clamping members are engaged with respective four corners of the electronic component including a planer shape of a quadrilateral.

4. The packaging structure as claimed in claim 1 or 2, **characterized in that**
the first end portion of the clamping member includes a frame shape to be engaged with an outer periphery of the electronic component, and
the second end portion that extends from the middle portion extending from the first end portion through the through-hole to a rear surface of the printed circuit board is bent toward the middle portion of the clamping member at a rear surface side of the printed circuit board.

5. The packaging structure as claimed in claim 1 or 2, **characterized in that**
the first end portion of the clamping member includes a frame shape corresponding to an outer periphery shape of the electronic component and is engaged with a rear surface of the printed circuit board, and the second end portion that extends from the middle portion extending from the first end portion through the through-hole to a surface of the printed circuit board is bent toward the middle portion of the clamping member at a surface side of the printed circuit board.

6. A printed circuit board assembly comprising:
a printed circuit board including an electrode pad arranged on a surface thereof;
an electronic component including an external connecting terminal connected to the electrode pad of the printed circuit board;
a through-hole penetrating through the printed circuit board, the through-hole formed in a periphery of an electronic component mounting area of the printed circuit board; and
a clamping member including a first end portion, a second end portion and a middle portion configured to sandwich the electronic component and the printed circuit board, the first end portion and the second end portion extending from the middle portion, the middle portion extending through the through-hole, wherein
the first end portion and the second end portion are bent such that the electronic component and the printed circuit board are sandwiched and clamped by the first end portion and the second end portion.

7. A method for fixing an electronic component to a printed circuit board, comprising:
allowing a clamping member including a first end portion and a second end portion to pass through a through-hole formed in the printed circuit board;
engaging the second end portion of the clamping member with a rear surface of the printed circuit board; and
engaging the first end portion of the clamping member with the electronic component.

8. The method as claimed in claim 7, further comprising:
forming the clamping member in a U-shape in advance;
allowing the first end portion of the clamping member to pass through the through-hole from a rear surface side of the printed circuit board such that the first end portion extends to a surface side thereof;
engaging the second end portion of the clamping member with the rear surface of the printed circuit board; and
engaging the first end portion of the clamping member with the electronic component while pulling the first end portion of the clamping member from the through-hole of the printed circuit board.

9. The method as claimed in claim 7, further comprising:
bending in advance the second end portion of the clamping member to be engaged with the rear surface of the printed circuit board;
allowing the first end portion of the clamping member to pass through the through-hole from the rear surface side of the printed circuit board such that the first end portion thereof extends to the surface side thereof; and
engaging the first end portion of the clamping member with the electronic component while bending the first end portion thereof at the surface side of the printed circuit board.
